# EUROPEAN PATENT SPECIFICATION

(11) **EP 2 291 446 B1**
(45) Date of publication and mention of the grant of the patent: **18.10.2017**
(21) Application number: 09770582.6
(22) Date of filing: 17.02.2009
(51) Int. Cl.: C08K 9/02, C08K 3/00, H05K 9/00

(54) **EMI SHIELDING MATERIALS**
FUNKENTSTÖRMATERIALIEN
MATÉRIAUX DE BLINDAGE EMI

(30) Priority: 23.06.2008 US 74748 P; 12.08.2008 US 88162 P
(43) Date of publication of application: 09.03.2011
(73) Proprietor: Parker-Hannifin Corporation, Cleveland, Ohio 44124-4141 (US)
(72) Inventor: WU, Junhua, Medford, Massachusetts 02155 (US); BROWN, Gerard, Melrose, Massachusetts 02176 (US); WATCHKO, George, Stoneham, Massachusetts 02180 (US); STEEVES, Robert, Nashua, New Hampshire 03060 (US); RICHARD, Francis, Derry, New Hampshire 03038 (US); LIONETTA, William, G., Harwich Port, Massachusetts 02646 (US)
(74) Representative: Atkinson, Ian Anthony
(86) International application number: PCT/US2009/034242
(87) International publication number: WO 2009/158045

(56) References cited:
- EP-A2- 1 052 653
- JP-A- 60 077 151
- JP-A- 2002 030 232
- JP-A- 2004 189 938
- DATABASE WPI Week 198632 Thomson Scientific, London, GB; AN 1986-208884 XP002525627 & JP 61 141762 A (KANEBO GOSEN KK) 28 June 1986 (1986-06-28)
- Anonymous: "Electroless nickel plating - Wikipedia, the free encyclopedia", , 8 May 2014 (2014-05-08), XP055137632, Retrieved from the Internet: URL:http://en.wikipedia.org/wiki/Electrole ss_nickel_plating [retrieved on 2014-09-02]

## Description

### BACKGROUND OF THE INVENTION

The present invention relates broadly to electromagnetic interference (EMI) shielding materials such as in the form of gaskets and gap fillers, backplanes, grounding pads and the like, and particularly to such materials which are corrosion resistant.

The operation of electronic devices such as televisions, radios, computers, medical instruments, business machines, communications equipment, and the like is attended by the generation of electromagnetic radiation within the electronic circuitry of the equipment. As is detailed in U.S. Patent Nos. 5,202,536; 5,142,101; 5,105,056; 5,028,739; 4,952,448; and 4,857,668, such radiation often develops as a field or as transients within the radio frequency band of the electromagnetic spectrum, i.e., between about 10 KHz and 10 GHz, and is termed "electromagnetic interference" or "EMI" as being known to interfere with the operation of other proximate electronic devices.

To attenuate EMI effects, shielding having the capability of absorbing and/or reflecting EMI energy may be employed both to confine the EMI energy within a source device, and to insulate that device or other "target" devices from other source devices. Such shielding is provided as a barrier which is inserted between the source and the other devices, and typically is configured as an electrically conductive and grounded housing which encloses the device. As the circuitry of the device generally must remain accessible for servicing or the like, most housings are provided with openable or removable accesses such as doors, hatches, panels, or covers. Between even the flattest of these accesses and its corresponding mating or faying surface, however, there may be present gaps which reduce the efficiency of the shielding by presenting openings through which radiant energy may leak or otherwise pass into or out of the device. Moreover, such gaps represent discontinuities in the surface and ground conductivity of the housing or other shielding, and may even generate a secondary source of EMI radiation by functioning as a form of slot antenna. In this regard, bulk or surface currents induced within the housing develop voltage gradients across any interface gaps in the shielding, which gaps thereby function as antennas which radiate EMI noise. In general, the amplitude of the noise is proportional to the gap length, with the width of the gap having less appreciable effect.

For filling gaps within mating surfaces of housings and other EMI shielding structures, gaskets and other seals have been proposed both for maintaining electrical continuity across the structure, and for excluding from the interior of the device such contaminates as moisture and dust. Such seals are bonded or mechanically attached to, or press-fit into, one of the mating surfaces, and function to close any interface gaps to establish a continuous conductive path thereacross by conforming under an applied pressure to irregularities between the surfaces. Accordingly, seals intended for EMI shielding applications are specified to be of a construction which not only provides electrical surface conductivity even while under compression, but which also has a resiliency allowing the seals to conform to the size of the gap. The seals additionally must be wear resistant, economical to manufacture, and capability of withstanding repeated compression and relaxation cycles. Requirements also may dictate a low impedance, low profile gasket which is deflectable under normal closure force loads. Other requirements include the ability to achieve a certain EMI shielding effectiveness for both the proper operation of the device and compliance, in the United States, with commercial Federal Communication Commission (FCC) EMC regulations.

EMI shielding gaskets typically are constructed as a resilient element, or a combination of one or more resilient elements having gap-filling capabilities. One or more of the elements may be provided as a tubular or solid, foamed or unfoamed core or strip which is filled to be electrically-conductive. Such core or strip may be extruded, molded, or otherwise formed of an elastomeric polymeric material. Conductive materials for the filler include metal or metal-plated particles.

Conventional manufacturing processes for EMI shielding gaskets include extrusion, molding, die-cutting, and form-in-place (FIP).

In view of the foregoing, it may be appreciated that many different types of materials employed in the production of EMI shielding material such as gaskets. As electronic devices continue to proliferate, it is believed that additional EMI shielding alternatives and options would be well-received by the electronics industry.

### SUMMARY OF THE INVENTION

The present invention relates to an assembly for shielding circuitry of an electronic device from electromagnetic interference ("EMI") as disclosed in claim 1. As compared to conventional silver-based, nickel, or nickel-graphite filled materials, at comparable volume loading levels, the nickel-aluminum fillers material as used in the assembly of the present invention exhibit comparable or improved EMI shielding effectiveness and corrosion resistance such as when in contact with an aluminum or nickel-plated housing or other device part.

Advantages of the present invention include an EMI shielding material which is both cost-effective and corrosion-resistant, and which exhibits superior EMI shielding effectiveness. These and other advantages will be readily apparent to those skilled in the art based upon the disclosure contained herein.

### BRIEF DESCRIPTION OF THE DRAWINGS

For a fuller understanding of the nature and objects of the invention, reference should be had to the following detailed description taken in connection with the accompanying drawings wherein:
Fig. 1 is a perspective end view, partially in cross-section, of a handheld electronic communication device representative of a typical application for the corrosion-resistant EMI shielding material used in the present invention;
Fig. 2 is a magnified view of a portion of the enclosure of Fig. 1 showing in enhanced detail the corrosion-resistant EMI shielding material used in the present invention as interposed between a first and a second housing part of the device of Fig. 1; and
Fig. 3 is a plot comparing the EMI shielding effectiveness of conventional EMI and those used in the present invention.

The drawings will be described further in connection with the following Detailed Description of the Invention.

### DETAILED DESCRIPTION OF THE INVENTION

Certain terminology may be employed in the following description for convenience rather than for any limiting purpose. For example, the terms "forward" and "rearward," "front" and "rear," "right" and "left," "upper" and "lower," "top" and "bottom," and "right" and "left" designate directions in the drawings to which reference is made, with the terms "inward," "inner," "interior," or "inboard" and "outward," "outer," "exterior," or "outboard" referring, respectively, to directions toward and away from the center of the referenced element, the terms "radial" or "vertical" and "axial" or "horizontal" referring, respectively, to directions or planes perpendicular and parallel to the longitudinal central axis of the referenced element. Terminology of similar import other than the words specifically mentioned above likewise is to be considered as being used for purposes of convenience rather than in any limiting sense. Further, the term "EMI shielding" should be understood to include, and to be used interchangeably with, electromagnetic compatibility (EMC), electrical conduction and/or grounding, corona shielding, radio frequency interference (RFI) shielding, and anti-static, i.e., electro-static discharge (ESD) protection, and the terms "magnetic," "dielectric," "ferritic," or "lossy" to be used interchangeably with EMI absorbing, absorptive, dissipating, dissipative, or attenuating, or as otherwise having a capability to attenuate electromagnetic energy by absorption or another dissipation mechanism.

In the figures, elements having an alphanumeric designation may be referenced herein collectively or in the alternative, as will be apparent from context, by the numeric portion of the designation only. Further, the constituent parts of various elements in the figures may be designated with separate reference numerals which shall be understood to refer to that constituent part of the element and not the element as a whole. General references, along with references to spaces, surfaces, dimensions, and extents, may be designated with arrows or underscores.

For the illustrative purposes of the discourse to follow, the corrosion-resistant EMI-shielding material used in the invention herein involved is principally described in connection with its use an extruded, form-in-place, molded or other gasket which is interposed between two components, each of which may be a housing, case, circuit board, door, cover, can, shield, integrated circuit chip, or other part of an electronic device such as a mobile, i.e., cellular, telephone handset, or other electronic device such as a personal communications services (PCS) handset, PCMCIA card, global positioning system (GPS), radio receiver, personal digital assistant (PDA), notebook or desktop personal computer (PC), cordless telephone handset, network router or server, medical electronics device, modem, wireless communication base station, telemetry device, telematic component or system, or the like.

In accordance with the precepts of the present invention, a corrosion-resistant electromagnetic interference ("EMI") shielding material is provided as an admixture of an elastomeric polymeric component, and a filler component. Such material may be provided as a cured or otherwise form-stable composition, such as in the form of a molded or extruded gasket profile, or as curable composition, such as for the spraying, dispensing, or other production of conformal coatings or form-in-place gaskets or gap fillers. By "cured" it is meant that the composition may be polymerized, cross-linked, further cross-linked or polymerized, vulcanized, cooled, hardened, or otherwise chemically or physically changed from a liquid or other fluent form into a sold or more solid or semi-solid elastomeric or polymeric phase or form.

The elastomeric polymeric component may be a thermoplastic or thermoset, and specifically may be selected as depending upon one or more of operating temperature, hardness, chemical compatibility, resiliency, compliancy, compression-deflection, compression set, flexibility, ability to recover after deformation, modulus, tensile strength, elongation, force defection, flammability, or other chemical or physical property. Depending upon the application, suitable materials, including blends, co-polymers, and other mixtures thereof, may include natural rubbers such as Hevea and thermoplastic, i.e., melt-processible, or thermosetting, i.e., vulcanizable, synthetic rubbers such as fluoropolymer, chlorosulfonate, polybutadiene, butyl, neoprene, nitrile, polyisoprene, buna-N, copolymer rubbers such as ethylene-propylene (EPR), ethylene-propylene-diene monomer (EPDM), nitrile-butadiene (NBR) and styrene-butadiene (SBR), or blends such as ethylene or propylene-EPDM, EPR, or NBR. The term "synthetic rubbers" also should be understood to encompass materials which alternatively may be classified broadly as thermoplastic or thermosetting elastomers such as polyurethanes, silicones, fluorosilicones, styrene-isoprene-styrene (SIS), and styrene-butadiene-styrene (SBS), as well as other polymers which exhibit rubber-like properties such as plasticized nylons, polyolefins, flexible epoxies, polyesters, ethylene vinyl acetates, fluoropolymers, and polyvinyl chloride. As used herein, the term "elastomeric" is ascribed its conventional meaning of exhibiting rubber-like properties of compliancy, resiliency or compression deflection, low compression set, flexibility, and an ability to recover after deformation, i.e., stress relaxation. Any of the forgoing materials may be used unfoamed or, if required by the application, blown or otherwise chemically or physically processed into an open or closed cell foam.

The elastomeric polymeric component generally may form a binder or other continuous or matrix phase into which the particulate filler component may be dispersed as a discrete phase. The filler generally may be included within the binder in a proportion sufficient to provide the level of EMI shielding effectiveness which is desired for the intended application. For most applications, an EMI shielding effectiveness of at least 10 dB, and usually at least 20 dB, and preferably at least about 40 dB or higher, over a frequency range of from about 20 MHz to 18 GHz may be considered acceptable. Such effectiveness translates to a filler proportion which generally is between about 10-50% by volume or 20-80% by weight, based on the total volume or weight, as the case may be, of the compound, and a bulk or volume resistivity of not greater than about 10 Ω-cm. However, the ultimate shielding effectiveness of the material can vary based on the amount of the EMI-absorptive filler, and of other fillers, such as other electrically-conductive fillers, and on the thickness of the material.

In accordance with the precepts of the present invention, the electrically-conductive filler component which is admixed with the elastomeric polymeric component is provided as aluminum particles which are electrolessly-plated with a plating of a nickel-phosphorous alloy. The plated particles may be of any shape, or combination of shapes, and may be referred broadly as being "particulate," which should be understood to include solid or hollow spheres and microspheres or microballoons, flakes, platelets, fibers, rods, irregularly-shaped particles, nodules, fibers, which may be chopped or milled or whiskers, and powders. For many applications the aluminum particles may take the form of spheres, flakes, or nodules .. The mean average particle size or distribution of the filler, which may be a diameter, imputed diameter, length, or other dimension of the particulate typically will range from about 0.01 mil (0.25 µm) to about 20 mils (500 µm), but preferably for fibers a length of less than about 16 mil (400 µm) with a length to width aspect ratio of between about 5-20. The nickel-phosphorous alloy is electrolessly plated on the underlying aluminum particles to form a plating thereon which plating may comprise less than about 40% of the weight of the filler.

Additional fillers and additives may be included in the formulation of the material depending upon the requirements of the particular application envisioned. Such fillers and additives, which may be functional or inert, may include wetting agents or surfactants, pigments, dispersants, dyes, and other colorants, opacifying agents, foaming or anti-foaming agents, anti-static agents, coupling agents such as titanates, chain extending oils, tackifiers, flow modifiers, pigments, lubricants such as molybdenum disulfide (MoS₂), silanes, peroxides, film-reinforcing polymers and other agents, stabilizers, emulsifiers, antioxidants, thickeners, and/or flame retardants and other fillers such as aluminum trihydrate, antimony trioxide, metal oxides and salts, intercalated graphite particles, phosphate esters, decabromodiphenyl oxide, borates, phosphates, halogenated compounds, glass, silica, which may be fumed or crystalline, silicates, mica, ceramics, and glass or polymeric microspheres. Typically, these fillers and additives are blended or otherwise admixed with the formulation, and may comprise between about 0.05-80% or more by total volume thereof. The formulation of the material may be compounded in a conventional mixing apparatus as an admixture of the polymeric and filler components, and any additional fillers or additives.

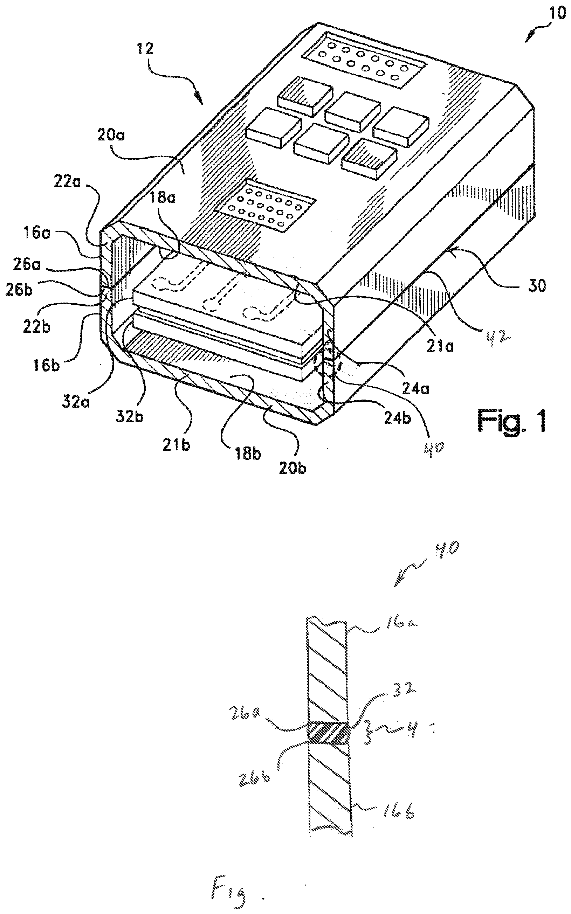

Referring now to the figures wherein corresponding reference characters are used to designate corresponding elements throughout the several views with equivalent elements being referenced with prime or sequential alphanumeric designations, an illustrative electronic device is shown generally at 10 in the perspective view of Fig. 1 as including a case, housing, or enclosure, reference generally at 12, which is modified in accordance with the precepts of the present invention as having a gasket, gap filler, coating or other layer, 14, of the EMI shielding material used in the present invention. For purposes of illustration, device 10 is shown to be a mobile telephone handset, but alternatively may be another handheld, portable, or other electronics device such as a personal communications services (PCS) handset, PCMCIA card, global positioning system (GPS), radio receiver, personal digital assistant (PDA), notebook or desktop personal computer (PC), cordless telephone handset, network router or server, medical electronics device, or the like. Enclosure 12 is shown to be of a 2-part construction including a upper half or cover, 16a, and a lower half or base, 16b, each of the parts 16a-b having a corresponding interior surface, 18a-b, and an exterior surface, 20a-b, which extend coterminously to form adjoining top and bottom walls, 21a-b, side walls, 22a-b and 24a-b, and end walls (not shown). The side and end walls together define the perimeters of each of the enclosure parts 16a-b, which is demarked by a peripheral edge surface, 26a-b. The edge surfaces 26 are mating and define a joint, parting line, or other interface, 30. As is shown, enclosure 12 may house one or more printed circuit boards (PCBs), 32a-b, or other circuitry of the device 10.

With additional reference to Fig. 2, the detail of Fig. 1 referenced at 40 is depicted in the magnified view of Fig. 2. As may be seen, a compressible gasket, gap filler, coating, or other form, 32, of the material used in the present invention is provided in the interface 30 as interposed between the surfaces 26 to provide electrical continuity and/or environmental sealing between the parts 16. For the purposes of the present invention, one or both of the enclosure parts 16a-b and/or the surfaces 26a-b, which may be constructed of the same or different materials, may be molded, cast, machined, or otherwise formed of aluminum or aluminum alloy.

### EXAMPLE

Samples of representative EMI shielding materials used in the present invention were prepared for characterization. Irregular glass particles (average size 150∼200 µm) and nodular-shaped aluminum particles (average size 100∼120 µm) each were electrolessly plated with 20% by weight of a nickel-phosphorous alloy (<6% phosphorous) to form fillers in accordance with the present invention. The mean average particle size of the nickel-glass filler was between about 150∼200 µm, and that of the nickel-aluminum fillers was between about 100∼120 µm.

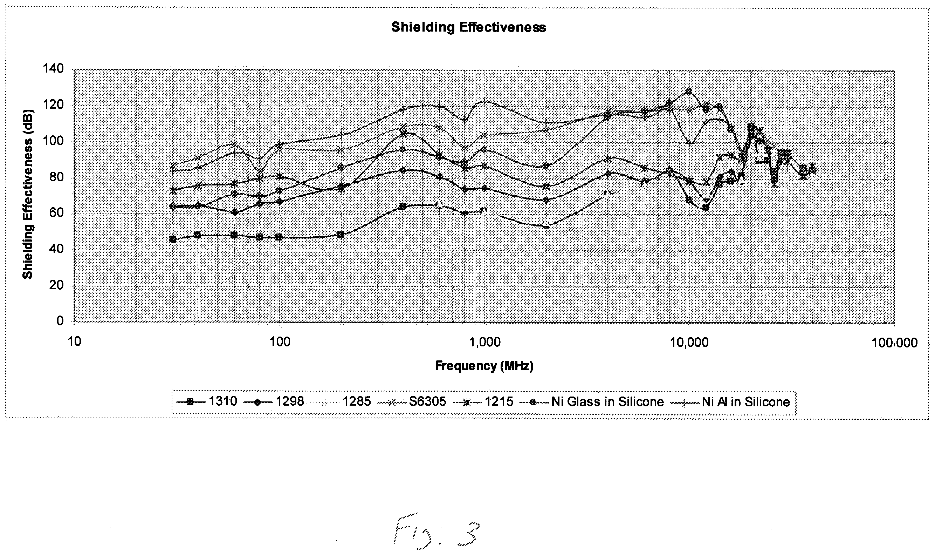

These nickel-glass and nickel-aluminum fillers were admixed at, respectively, 39.2% and 38.6% by volume with a methyl and phenyl, peroxide-cured silicone to form EMI shielding compositions. The galvanic corrosion resistance on hexavalent chromated aluminum (per CHO-TM100, Chomerics Test Procedure, Parker Chomerics Division, Woburn, MA), initial volume resistivity (per ASTM D991), and initial EMI shielding effectiveness (per Chomerics Test Procedure CHO-TM-TP08) of these materials was determined and compared to conventional materials. The results are summarized in the table below and in the EMI shielding effectiveness plot of Fig. 3

**TABLE**

| | | **Corrosion Resistance** | | |
|---|---|---|---|---|
| | **Conductive Filler** | 168 hrs Wt. Loss | 504 hrs Wt. Loss | **Volume Resistivity** |
| **Elastomer** | (% by volume) | (mg) | (mg) | (mOhm-cm) |
| Silicone¹ | 40.3% Ag-Al | 7-11 | 26 | 3.5-5.1 |
| Fluorosilicone ² | 41.8% Ag-Al | 4-7 | 45 | 5.5 |
| Fluorosilicone ³ | 41.4% Ag-Al | 3-5 | 23 | 4-6 |
| Silicone ⁴ | 47.7% Ag-glass | 132 | | 5 |
| Silicone ⁵ | 32.6% Ni-graphite | 28-63 | 138 | 36 |
| Silicone ⁶ | 37.4% Ni | 21-26 | 52 | 41-48 |
| Silicone ⁷ | 24.5% Ni-graphite | 18 | 46 | 128-260 |
| Silicone | 39.2% Ni-glass | 3-6 | 7-13 | 356-832 |
| Silicone | 38.6% Ni-Al | 2-7 | 6-17 | 57-99 |

| | | | | |
|---|---|---|---|---|
| ¹Cho-Seal 1285, Parker Chomerics Division, Woburn, MA ²Cho-Seal 1287, Parker Chomerics Division, Woburn, MA ³Cho-Seal 1298, Parker Chomerics Division, Woburn, MA ⁴Cho-Seal 1310, Parker Chomerics Division, Woburn, MA ⁵Cho-Seal S6305, Parker Chomerics Division, Woburn, MA ⁶Cho-Seal 6313, Parker Chomerics Division, Woburn, MA ⁷Cho-Seal 6330, Parker Chomerics Division, Woburn, MA | | | | |

These data show that as compared to conventional silver-based, nickel, or nickel-graphite filled materials, at comparable volume loading levels, the nickel-glass and nickel-aluminum fillers material exhibit comparable or improved EMI shielding effectiveness and corrosion resistance such as when in contact with an aluminum substrate.

Advantageously, the use of the EMI shielding materials according to the present invention instead of silver-based materials can significantly reduce costs while providing comparable shielding effectiveness. Such materials, moreover, in offering improved corrosion resistance, such as when used in contact with aluminum or nickel-plated substrates, can extend the service life of seals, gaskets, gap fillers, coatings, and other products in maintaining their shielding and moisture sealing performance in uncontrolled environments.

## Claims

1. An assembly for shielding circuitry of an electronic device from electromagnetic interference ("EMI"), the assembly comprising an EMI shielding material disposed intermediate a first and a second surface of the device in which one of the first and second surfaces of the device is formed from aluminium or an alloy thereof, the material comprising an admixture of:
(a) an elastomeric polymeric component, and
(b) a filler component comprising aluminium particles,
**characterised in that** the particles are electrolessly-plated with a plating comprising a nickel-phosphorous alloy.

2. The assembly of claim 1 in which the material comprises, by total weight of the components (a) and (b), from 20 to 80% of the filler component.

3. The assembly of claim 1 in which the material comprises, by total volume of the components (a) and (b), from 10 to 50% of the filler component.

4. The assembly of claim 1 in which the polymeric component comprises one or more thermosetting or thermoplastic polymers or co-polymers, or a blend thereof.

5. The assembly of claim 1 in which the nickel-phosphorous alloy comprises less than 10% by weight of the alloy of phosphorous.

6. The assembly of claim 1 in which the filler comprises less than 40% by weight of the plating.

7. A method of shielding circuitry of an electronic device from electromagnetic interference ("EMI"), the method comprising the step of disposing an EMI shielding material intermediate a first and a second surface of the device in which one of the first and second surfaces of the device is formed from aluminium or an alloy thereof, the material comprising an admixture of:
(a) an elastomeric polymeric component, and
(b) a filler component comprising aluminium particles,
in which the particles are electrolessly-plated with a plating comprising a nickel-phosphorous alloy.

8. The method of claim 7 in which the material comprises, by total weight of the components (a) and (b), from 20 to 80% of the filler component.

9. The method of claim 7 in which the material comprises, by total volume of the components (a) and (b), from 10 to 50% of the filler component.

10. The method of claim 7 in which the polymeric component comprises one or more thermosetting or thermoplastic polymers or co-polymers, or a blend thereof.

11. The method of claim 7 in which the nickel-phosphorous alloy comprises less than 10% by weight of the alloy of phosphorous.

12. The method of claim 7 in which the filler comprises less than 40% by weight of the plating.

## Patentansprüche

1. Ein Aufbau zur Abschirmung von Schaltungen eines elektronischen Geräts gegen elektromagnetische Interferenzen ("EMI"), wobei der Aufbau ein EMI Abschirmmaterial umfasst, das zwischen einer ersten und einer zweiten Oberfläche des Geräts angeordnet ist, wobei die erste oder die zweite Oberfläche des Geräts aus Aluminium oder einer Legierung davon gebildet ist, wobei das Material einen Zusatz umfasst aus:
(a) einer elastomeren polymeren Komponente, und
(b) einer Füllstoffkomponente, die Aluminiumpartikel umfasst,
**dadurch gekennzeichnet, dass** die Partikel stromlos mit einer Plattierung plattiert sind, die eine Nickel-Phosphor-Legierung umfasst.

2. Der Aufbau nach Anspruch 1, in dem das Material von 20 bis 80 Gew.-% der Füllstoffkomponente bezogen auf das Gesamtgewicht der Komponenten (a) und (b) umfasst.

3. Der Aufbau nach Anspruch 1, in dem das Material von 10 bis 50 Vol.-% der Füllstoffkomponente bezogen auf das Gesamtvolumen der Komponenten (a) und (b) umfasst.

4. Der Aufbau nach Anspruch 1, in dem die polymere Komponente ein oder mehrere duroplastische oder thermoplastische Polymere oder Copolymere oder eine Mischung daraus umfasst.

5. Der Aufbau nach Anspruch 1, in dem die Nickel-Phosphor-Legierung weniger als 10 Gew.-% Phosphor bezogen auf das Gewicht der Legierung umfasst.

6. Der Aufbau nach Anspruch 1, in dem der Füllstoff weniger als 40 Gew.-% der 30 Plattierung umfasst.

7. Ein Verfahren zum Abschirmen von Schaltungen eines elektronischen Geräts gegen elektromagnetische Interferenzen ("EMI"), wobei das Verfahren einen Schritt zum Anordnen eines EMI-Abschirmmaterials zwischen einer ersten und einer zweiten Oberfläche des Geräts umfasst, wobei die erste oder die zweite Oberfläche des Gerats aus Aluminium oder einer Legierung davon gebildet ist, wobei das Material einen Zu- satz umfasst aus:
(a) einer elastomeren polymeren Komponente, und
(b) einer Füllstoffkomponente, die Aluminiumpartikel umfasst,
**dadurch gekennzeichnet, dass** die Partikel stromlos mit einer Plattierung plattiert sind, die eine Nickel-Phosphor-Legierung umfasst.

8. Das Verfahren nach Anspruch 7, in dem das Material von 20 bis 80 Gew.-% der Füllstoffkomponente bezogen auf das Gesamtgewicht der Komponenten (a) und (b) umfasst.

9. Das Verfahren nach Anspruch 7, in dem das Material von 10 bis 50 Vol.-% der Füllstoffkomponente bezogen auf das Gesamtvolumen der Komponenten (a) und (b) umfasst.

10. Das Verfahren nach Anspruch 7, in dem die polymere Komponente ein oder mehrere duroplastische oder thermoplastische Polymere oder Copolymere oder eine Mischung daraus umfasst.

11. Das Verfahren nach Anspruch 7, in dem die Nickel-Phosphor-Legierung weni- ger als 10 Gew.-% Phosphor bezogen auf das Gewicht der Legierung umfasst.

12. Das Verfahren nach Anspruch 7, in dem der Füllstoff weniger als 40 Gew.-% der Plattierung umfasst.

## Revendications

1. Ensemble pour protéger des circuits d'un dispositif électronique contre une interférence électromagnétique (« EMI »), l'ensemble comprenant un matériau de protection contre l'EMI disposé entre des première et deuxième surfaces du dispositif dans lequel l'une des première et deuxième surfaces du dispositif est formée d'aluminium ou d'un alliage de celui-ci, le matériau comprenant un mélange :
(a) d'un composant polymère élastomère, et
(b) d'un composant de charge comprenant des particules d'aluminium,
**caractérisé en ce que** les particules sont soumises à un placage non électrolytique avec un placage comprenant un alliage nickel-phosphore.

2. Ensemble de la revendication 1, dans lequel le matériau comprend, en poids total des composants (a) et (b), 20 à 80% du composant de charge.

3. Ensemble de la revendication 1, dans lequel le matériau comprend, en volume total des composants (a) et (b), 10 à 50% du composant de charge.

4. Ensemble de la revendication 1, dans lequel le composant polymère comprend un ou plusieurs polymère(s) ou copolymère(s) thermodurcissable(s) ou thermoplastique(s), ou un mélange de ceux-ci.

5. Ensemble de la revendication 1, dans lequel l'alliage nickel-phosphore comprend moins de 10% en poids de l'alliage de phosphore.

6. Ensemble de la revendication 1, dans lequel la charge comprend moins de 40% en poids du placage.

7. Procédé de protection de circuits d'un dispositif électronique contre une interférence électromagnétique (« EMI »), le procédé comprenant l'étape qui consiste à disposer un matériau de protection contre l'EMI entre des première et deuxième surfaces du dispositif dans lequel l'une des première et deuxième surfaces du dispositif est formée d'aluminium ou d'un alliage de celui-ci, le matériau comprenant un mélange :
(a) d'un composant polymère élastomère, et
(b) d'un composant de charge comprenant des particules d'aluminium,
dans lequel les particules sont soumises à un placage non électrolytique avec un placage comprenant un alliage nickel-phosphore.

8. Procédé de la revendication 7, dans lequel le matériau comprend, en poids total des composants (a) et (b), 20 à 80% du composant de charge.

9. Procédé de la revendication 7, dans lequel le matériau comprend, en volume total des composants (a) et (b), 10 à 50% du composant de charge.

10. Procédé de la revendication 7, dans lequel le composant polymère comprend un ou plusieurs polymère(s) ou copolymère(s) thermodurcissable(s) ou thermoplastique(s), ou un mélange de ceux-ci.

11. Procédé de la revendication 7, dans lequel l'alliage nickel-phosphore comprend moins de 10% en poids de l'alliage de phosphore.

12. Procédé de la revendication 7, dans lequel la charge comprend moins de 40% en poids du placage.
